(19) Europäisches Patentamt

European Patent Office

Office européen des brevets

(11) EP 0 399 758 B1

## (12) EUROPEAN PATENT SPECIFICATION

(45) Date of publication and mention
of the grant of the patent:
**17.07.1996 Bulletin 1996/29**

(51) Int Cl.⁶: **H03D 3/04**, H04N 5/91

(21) Application number: **90305485.6**

(22) Date of filing: **21.05.1990**

(54) **FM-demodulating apparatus**

FM-Demodulator

Démodulateur FM

(84) Designated Contracting States:
**DE FR GB**

(30) Priority: **25.05.1989 JP 132220/89**
**16.01.1990 JP 6835/90**

(43) Date of publication of application:
**28.11.1990 Bulletin 1990/48**

(73) Proprietor: **SONY CORPORATION**
**Tokyo 141 (JP)**

(72) Inventor: **Sakamoto, Etsurou**
**Shinagawa-ku, Tokyo (JP)**

(74) Representative: **Ayers, Martyn Lewis Stanley et al**
**J.A. KEMP & CO.**
**14 South Square**
**Gray's Inn**
**London WC1R 5LX (GB)**

(56) References cited:
**EP-A- 0 165 066**       **EP-A- 0 289 346**
**DE-B- 1 233 028**       **FR-A- 2 162 384**
**FR-A- 2 170 152**       **GB-A- 2 143 386**
**US-A- 2 922 040**       **US-A- 3 818 355**

- **ELEKTRONIK. vol. 35, no. 11, May 1986,
MUNCHEN DE pages 67 - 70; S.MEHRGARDT:
'Digitale Signalverarbeitung auch in
Videorecordern'**
- **ARCHIV FUR ELEKTRONIK UND
UBERTRAGUNGSTECHNIK. vol. 25, no. 3, March
1971, STUTTGART DE pages 155 - 159;
P.LEUTHOLD: 'Transversalfilter zur Erzeugung
von Funktionspaaren, die durch die
Hilbert-Transformation verknüpft sind'**

## Description

The present invention relates generally to FM-demodulating apparatus and, more particularly, is directed to an FM-demodulating apparatus suitable for use in a video tape recorder (VTR) to demodulate a video signal which is FM-modulated and then recorded.

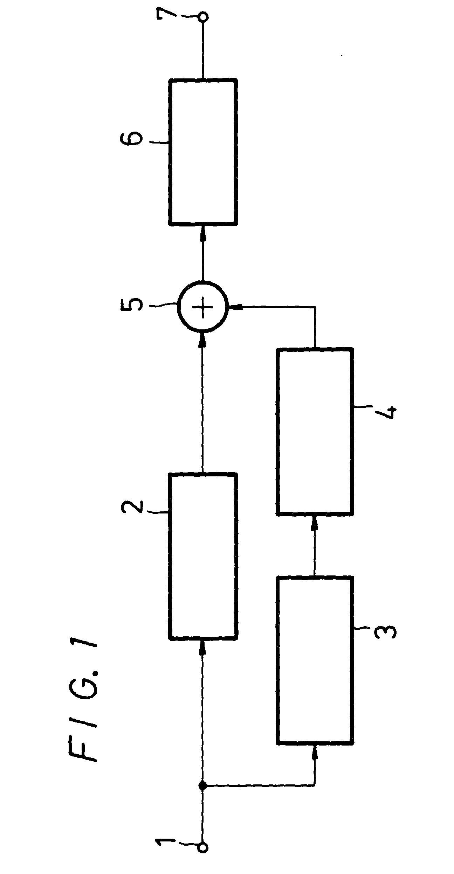

A prior art video tape recorder (VTR) utilises an FM-demodulating apparatus to FM-demodulate a reproduced signal of an FM luminance signal recorded on a magnetic tape. Figure 1 of the accompanying drawings shows an example of a previously-proposed FM-demodulating apparatus (see Japanese Patent Laid-Open Gazette No 60-119104).

Referring to figure 1, an input terminal 1 is supplied with a video signal which is FM-modulated by a carrier of a relatively low frequency and reproduced by a video tape recorder or the like. The FM-modulated video signal applied to the input terminal 1 is supplied to an FM-demodulator 2 of a pulse count type and to a 90-degrees phase shifting circuit 3. The 90-degrees phase shifting circuit 3 shifts, ie, delays the phase of the input video signal by 90 degrees. A video signal from the 90-degrees phase shifting circuit 3 is supplied to an FM-demodulator 4 of a pulse count type. Demodulated signals from the two FM-demodulators 2 and 4 are supplied to an adder 5, and an added signal from the adder 5 is supplied to a low-pass filter 6. Thus, the high frequency component of the added signal is filtered-out by the low-pass filter 6 and is then fed to an output terminal 7. Therefore, the FM-demodulated video signal is developed at the output terminal 7. In the FM-demodulated video signal at the output terminal 7, the occurrence of so-called moire, ie, an undesirable high frequency component produced around a frequency twice that of the carrier due to the sideband waves can be alleviated.

Recently, a video signal transmitting system is developed, in which a picture of high resolution, ie, a high-definition television picture is displayed. This high-definition television system processes a signal involving a high band component having a bandwidth wider than that of the video signal according to the standard broadcasting systems such as the NTSC system or the like. For this reason, when a high-definition television video signal is demodulated by the above-described FM-demodulating apparatus, the undesirable high frequency component produced about the frequency twice the carrier frequency due to the sideband waves cannot be satisfactorily suppressed.

As described above, this undesirable high frequency component produced about the frequency twice that of the carrier due to the sideband wave is what might be called a moire. The moire occurs because the frequency characteristics of the input signal to the FM-demodulator 2 and the input signal to the FM-demodulator 4 are changed by the phase-shifting operation in the 90-degrees phase shifting circuit 3.

EP-A-0,165,066 discloses an FM signal demodulator in which the signal is provided to an odd- and an even-type transversal filter, the outputs of which have a 90° phase difference.

ARCHIV FUR ELEKTRONIK UND UBERTRAGUNGSTECHNIK, vol. 25, no. 3, March 1971, pp 155-159 discloses the use of doubly tapped delay lines to generate signal pairs with a 90° phase difference.

According to the present invention, there is provided an FM-demodulating apparatus comprising:

input means to which, in use, FM-modulated video signals are supplied;
a Hilbert transform circuit coupled to said input means for phase-shifting said FM-modulated signals by 90 degrees, said Hilbert transform circuit including delay circuits and a subtracting circuit coupled to said input means and the output of said delay circuits
first adding means coupled to said input means and the output of said delay circuits included in said Hilbert transform circuit;
a first demodulator circuit coupled to the output of said adding means for demodulating signals obtained from said first adding means;
a second demodulating circuit coupled to the output of said subtracting circuit of the Hilbert transform circuit for demodulating signals obtained from said subtracting circuit; and
second adding means coupled to the respective outputs of said first and second demodulating circuits for deriving FM-demodulated video signals.

The invention will be further described by way of non-limitative example with reference to the accompanying drawings, in which:-

Figure 1 is a block diagram showing an example of a prior art FM-demodulating apparatus;
Figure 2 is a block diagram showing a first embodiment of an FM-demodulating apparatus according to the present invention;
Figure 3 is a schematic diagram showing an example of a pulse count type demodulating circuit used in the present invention;
Figures 4A to 4C are waveform diagrams of an input signal, a delay signal and an output signal used in the present invention, and to which reference will be made in explaining an operation of the pulse count type demodulating circuit shown in Figure 3;

Figures 5A to 5E are waveform diagrams to which reference will be made in explaining an operation of the embodiment shown in Figure 2; and

Figure 6 is a diagram of a frequency characteristic graph used to explain the embodiment of the present invention.

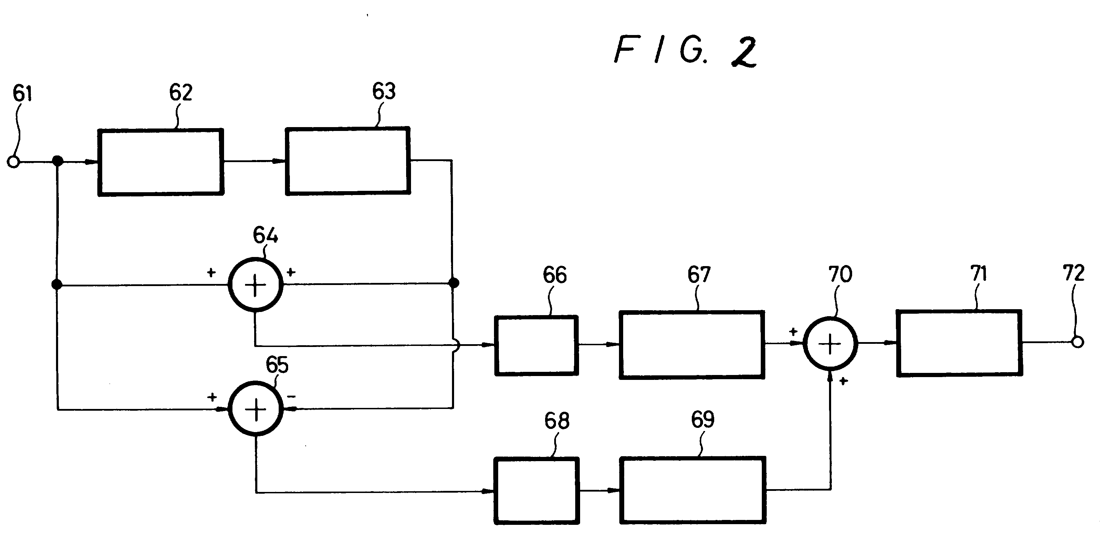

Referring to figure 2, there is shown a video signal input terminal 61 to which an FM-modulated video signal reproduced from a video tape recorder or the like is supplied. The video signal applied to the input terminal 61 is supplied to a series circuit of first and second delay circuits 62 and 63 which form a first-order Hilbert transform circuit. The video signal applied to the input terminal 61 is also supplied to an adder 64, and an output signal from the second delay circuit 63 is supplied to the adder 64, thereby generated as an added output. The video signal applied to the input terminal 61 is further supplied to a subtractor 65 and the output signal from the second delay circuit 63 is supplied to the subtractor 65, in which the output signal of the second delay circuit 63 is subtracted from the video signal applied to the input terminal 61, thereby provided a subtracted signal.

Accordingly, the first and second delay circuits 62 and 63 and the subtractor 65 constitute the first-order Hilbert transform circuit, whereby the subtracted output of the subtractor 65 becomes a signal whose phase is shifted by 90 degrees relative to the added output of the adder 64. In this embodiment, the delay time $\tau$ of each of the first and second delay circuits 62 and 63 forming the Hilbert transform circuit is selected such that the FM signal, provided as the output of this Hilbert transform circuit, can be prevented from being affected by a zero point.

The added output of the adder 64 is supplied through a limiter 66 to a first demodulating circuit 67, and the subtracted output of the subtractor 65 is supplied through a limiter 68 to a second demodulating circuit 69. Demodulated outputs from the first and second demodulating circuits 67 and 69 are supplied to an adder 70. In that case, as the first and second demodulating circuits 67 and 69, there can be utilised FM-demodulating circuits of pulse count type whose characteristics are equal.

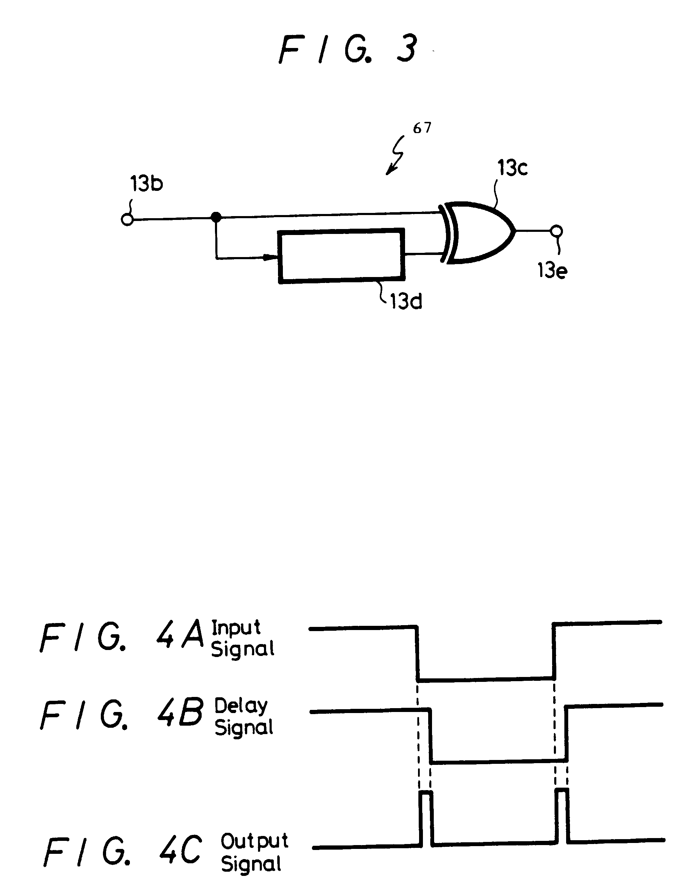

An arrangement of the pulse count type FM-demodulating circuit 67 will be described more fully with reference to Figure 3.

Referring to Figure 3, an FM-modulated signal applied to an input terminal 13b is directly supplied to one input terminal of an exclusive-OR gate 13c, and is also supplied through a delay circuit 13d to the other input terminal of the exclusive-OR circuit 13c. An exclusive-OR output from the exclusive-OR gate 13c is fed to an output terminal 13e of the FM-demodulating circuit.

The FM-demodulating circuit is constructed as described above so that, when an FM-modulated signal shown in Figure 4A is supplied to the input terminal 13b, the exclusive-OR gate 13c computes an exclusive-OR output between this input signal and a signal (shown in Figure 4B) delayed by the delay circuit 13d. Thus, a pulse signal whose waveform is shown in Figure 4C is developed at the output terminal 13e.

As is clear from the waveform diagrams of Figures 4A to 4C, the number of pulses output is changed in response to the frequency of the input signal, and this output pulse is supplied to a low-pass filter 71 connected to the later stage of the FM-demodulating circuit, resulting in a demodulated signal being developed at the output terminal 72. The second demodulating circuit 69 is constructed in a similar fashion.

The demodulated outputs of the first and second demodulating circuits 67 and 69 are added by the adder 70, and the added output of the adder 70 is supplied through a low-pass filter 71 to an output terminal 72.

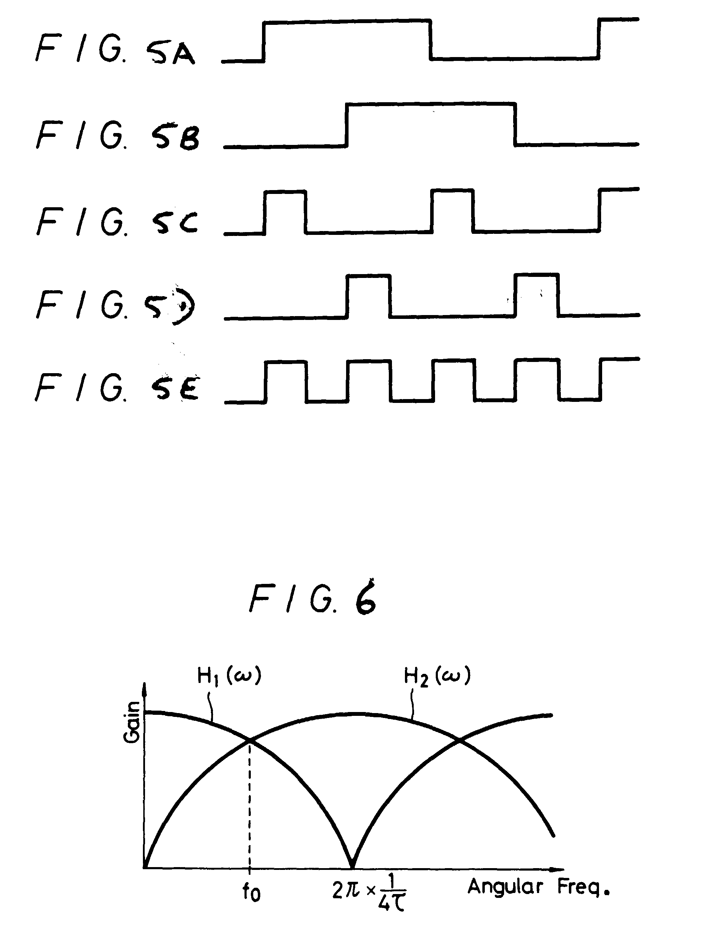

The operation of the FM-demodulating apparatus thus constructed will be described with reference to figures 5A to 5E and Fiqure 6.

When an FM-modulated signal whose waveform is shown in figure 5A is applied to the input terminal 61, the adder 64 generates this FM-modulated signal having no specified delay time of the delay circuit 62 and which has no phase difference as an added output thereof, and the subtractor 65 generates as a subtracted output thereof a signal whose phase is deviated from the phase of the input FM-modulated signal by 1/4 cycle (90 degrees) as shown in figure 5B. The two output signals from the adder 64 and the subtractor 65 are respectively supplied through the limiters 66 and 68 to the first and second demodulating circuits 67 and 69, from which there are derived demodulated signals with phases deviated by 1/4 cycle as shown in figures 5C and 5D. The two demodulated signals of the first and second demodulating circuits 67 and 69 are added by the adder 70, and the adder 70 then generates as an added signal thereof a signal having undesirable high frequency components as high as four times the carrier as shown in Figure 5E. This added signal is supplied to the low-pass filter 71 which attenuates the undesirable high frequency component by more than four times the carrier, and a signal component from the low-pass filter 71 is fed to the output terminal 72.

An undesirable high frequency component twice as high as the carrier is not produced in the thus generated demodulated signal, thereby a burden on the low-pass filter 71 being reduced. Therefore, even when the low-pass filter 71 is low in accuracy, the FM-demodulating circuit of this embodiment can generate an excellent demodulated signal having no undesirable high frequency component. In that case, since the demodulated signal is processed by the Hilbert transform circuit serving as the 90-degrees phase shifting circuit, the frequency characteristic of the demodulated signal is not changed by the carrier and the undesirable high frequency components can be eliminated satisfactorily.

This will be described more fully in conjunction with equations.

Initially, assuming that the delay times of the first and second delay circuits 62 and 63 be represented as $\tau$, then the transfer function $H_1(\omega)$ of the added output from the adder 64 and the transfer function $H_2(\omega)$ of the subtracted output from the subtractor 65 are expressed by the following equations.

$$H_1(\omega) = 2 \cdot e^{-j\omega\tau} \cdot \cos \omega\tau \tag{6}$$

$$H_2(\omega) = 2 \cdot e^{-j\omega\tau} \cdot j \cdot \sin \omega\tau \tag{7}$$

Figure 10 illustrates frequency characteristics provided by the transfer functions $H_1(\omega)$ and $H_2(\omega)$ which are given by the aforenoted equations (6) and (7). In this embodiment, the carrier frequency $f_o$ of the FM-modulated wave is selected to be a value at which gains of the two transfer functions $H_1(\omega)$ and $H_2(\omega)$ become equal to each other, as shown in figure 6.

Assuming that the angular frequency of carrier is represented by $\omega_o$ and that the modulated angular frequency of carrier is represented by $\omega m$, then outputs $E_{FM}$ supplied to the first and second demodulating circuits 67 and 69 from the limiters 66 and 68 are generally expressed by the following equation.

$$E_{FM} = \sin(\omega_0 t) + \rho_1 \cdot \sin(\omega_0 + \omega m) t$$

$$- \rho_{-1} \cdot \sin(\omega_0 - \omega m)t \tag{8}$$

In the equation (8), it is assumed that the side bands higher than the second side band are sufficiently small. Further, $\rho_1$ is the amplitude of the first upper side band wave relative to the carrier where $\rho_1 = J_1(\beta)/J_0(\beta)$, whereas $\rho_{-1}$ is the amplitude of the first lower side band wave relative to the carrier where $\rho_{-1} = J_1(\beta)/J_0(\beta)$.

Let it now be assumed that the modulation figure $\beta$ is small. Then, outputs $E_{FM}$ of the first and second limiters 66 and 68 are expressed by the following equation.

$$E_{FM} \fallingdotseq \sin(\omega_o t) + \frac{\rho_1 + \rho_{-1}}{2} \cdot \{\sin(\omega_0 + \omega m) t$$

$$- \sin(\omega_o - \omega m) t\} \tag{9}$$

Calculating the output $E_{FM1}$ of the first limiter 66 by substituting the transfer function of the equation (6) into the equation (9) yields

$$E_{FM1} \fallingdotseq \sin(\omega_0 t) + \rho_0 \frac{H_1(\omega_0 + \omega m) + H_1(\omega_0 - \omega m)}{2 \cdot H_1(\omega_0)}$$

$$\cdot \{\sin(\omega_0 + \omega m) t - \sin(\omega_0 - \omega m) t\}$$

$$= \sin \omega_0 t + \rho_0 \cdot \cos(\omega m \cdot \tau)$$

$$\cdot \{\sin(\omega_0 + \omega m) t - \sin(\omega_0 - \omega m) t\} \tag{10}$$

where

$$\rho_0 = \frac{\rho_1 + \rho_{-1}}{2}$$

is established.

Further, calculating the output $E_{FM2}$ of the second limiter 68 by substituting the transfer function of the equation (7) into the equation (9) yields

$$E_{FM2} \fallingdotseq \sin\left(\omega_0 t + \frac{\pi}{2}\right) + \rho_0 \cdot \cos(\omega m \cdot \tau)$$

$$\cdot \{\sin\left(\omega_0 + \omega m + \frac{\pi}{2}\right) t - \sin\left(\omega_0 - \omega m + \frac{\pi}{2}\right) t\} \tag{11}$$

Where, $\rho_0 \cdot \cos(\omega m \cdot \tau)$ in equations (10) and (11) becomes the modulation figure $\beta$. Accordingly, in equations (10) and (11), the FM-demodulated video signals becomes video signals in which the two modulation figures are the same and only the phases are different by 90 degrees (ie, $\pi/2$) so that the undesirable high frequency components are cancelled out by the addition of the adder 70.

According to the FM-demodulating circuit of this embodiment, the undesirable high frequency component twice as high as the carrier can be removed and the so-called moire can be removed. Therefore, the modulation figure β which is the ratio between the deviation frequency and the modulation frequency can be equivalently increased so that the moire can be prevented from being increased in the low carrier. Also, the S/N ratio of the demodulated video signal can be improved, whereby the high definition television video signal can be demodulated.

According to the FM-demodulating apparatus of the present invention, the occurrence of the undesirable high frequency components twice as high as the carrier can be suppressed in a video signal such as the high definition television video signal which is extended in the high band, whereby the S/N ratio of the demodulation signal can be improved. In other words, the moire due to the side band wave twice the carrier frequency can be reduced and the modulation figure β can be correspondingly increased. Further, the carrier frequency can be decreased so that the S/N ratio can be improved without increasing the moire in the FM-modulating signal having the low carrier. Furthermore, the moire occurring in the edge portion of the synchronising signal can be reduced, thus making it possible to detect a jitter component from a reproduced synchronising signal.

**Claims**

1. An FM-demodulating apparatus comprising:

   input means (61) to which, in use, FM-modulated video signals are supplied;
   a Hilbert transform circuit (62, 63, 65) coupled to said input means for phase-shifting said FM-modulated signals by 90 degrees, said Hilbert transform circuit including delay circuits (62, 63) and a subtracting circuit (65) coupled to said input means (61) and the output of said delay circuits;
   first adding means (64) coupled to said input means and the output of said delay circuits (62, 63) included in said Hilbert transform circuit;
   a first demodulator circuit (67) coupled to the output of said adding means (64) for demodulating signals obtained from said first adding means (64);
   a second demodulating circuit (69) coupled to the output of said subtracting circuit (65) of the Hilbert transform circuit for demodulating signals obtained from said subtracting circuit (65); and
   second adding means (70) coupled to the respective outputs of said first and second demodulating circuits for deriving FM-demodulated video signals.

2. An FM-demodulating apparatus as cited in claim 1, further comprising a low pass filter circuit (18, 71) coupled to said mixing circuit for eliminating undesirable high frequency components.

**Patentansprüche**

1. FM-Demodulator mit

   einem Eingang (61), dem im Betrieb frequenzmodulierte Videosignale zugeführt werden,
   einer mit dem Eingang (61) verbundenen Hilbert-Transformationsschaltung (62, 63, 65) zur Phasenverschiebung der frequenzmodulierten Signale um 90°, wobei diese Hilbert-Transformationsschaltung Verzögerungsschaltungen (62, 63) aufweist sowie eine Subtrahierschaltung (65), die mit dem genannten Eingang (61) und mit dem Ausgang der Verzögerungsschaltungen verbunden ist,
   einer ersten Addiereinrichtung (64), die mit dem Eingang und den Verzögerungsschaltungen (62, 63) in der Hilbert-Transformationsschaltung verbunden ist,
   einer mit dem Ausgang der Addiereinrichtung (64) verbundenen ersten Demodulatorschaltung (67) zum Demodulieren der aus der ersten Addiereinrichtung (64) gewonnenen Signale,
   einer mit dem Ausgang der Subtrahierschaltung (65) der Hilbert-Transformationsschaltung verbundenen zweiten Demodulatorschaltung (69) zum Demodulieren der aus der Subtrahierschaltung (65) gewonnenen Signale, und
   einer mit den Ausgängen der ersten und der zweiten Demodulatorschaltung verbundenen zweiten zur Gewinnung frequenzdemodulierter Videosignale.

2. FM-Demodulator nach Anspruch 1 mit einer mit der Mischschaltung verbundenen Tiefpaßfilterschaltung (18, 71) zur Eliminierung von unerwünschten Hochfrequenzkomponenten.

**Revendications**

1. Démodulateur FM comportant :

   des moyens d'entrée (61) auxquels, en utilisation, des signaux vidéo FM modulés sont délivrés;
   un circuit de transformée de Hilbert (62, 63, 65) couplé auxdits moyens d'entrée pour déphaser lesdits signaux FM modulés de 90 degrés, ledit circuit de transformée de Hilbert comprenant des circuits de retard (62, 63) et un circuit de soustraction (65) couplés auxdits moyens d'entrée (61) et à lasortie desdits circuits de retard;
   des premiers moyens additionneurs (64) couplés auxdits moyens d'entrée et à la sortie desdits circuits de retard (62, 63) compris dans ledit circuit de transformée de Hilbert;
   un premier démodulateur (67) couplé à la sortie desdits moyens d'addition (64) pour démoduler les signaux obtenus desdits premiers moyens d'addition (64);
   un second démodulateur (69) couplé à la sortie dudit circuit de soustraction (65) du circuit de transformée de Hilbert pour démoduler les signaux obtenus dudit circuit de soustraction (65); et
   des seconds moyens d'addition (70) couplés aux sorties respectives desdits premier et second démodulateurs pour extraire les signaux vidéo FM démodulés.

2. Démodulateur FM selon la revendication 1, comportant en outre un circuit de filtre passe-bas (18, 71) couplé audit circuit de mélange pour éliminer les composantes à haute fréquence indésirables.

F I G. 1

EP 0 399 758 B1

F I G. 2

EP 0 399 758 B1

# F I G. 3

# F I G. 4A Input Signal

# F I G. 4B Delay Signal

# F I G. 4C Output Signal

FIG. 5A

FIG. 5B

FIG. 5C

FIG. 5D

FIG. 5E

FIG. 6

$H_1(\omega)$      $H_2(\omega)$

Gain

$f_0$    $2\pi \times \dfrac{1}{4\tau}$    Angular Freq.